# FASCICULE DE BREVET EUROPEEN

(11) **EP 0 611 203 B1**
(45) Date de publication et mention de la délivrance du brevet: **06.05.1998**
(21) Numéro de dépôt: 94400267.4
(22) Date de dépôt: 08.02.1994
(51) Int. Cl.: H01L 37/02

(54) **Procédé de réalisation d'un détecteur thermique**
Verfahren zur Herstellung eines thermischen Detektors
Process of producing a thermal detector

(30) Priorité: 12.02.1993 FR 9301609
(43) Date de publication de la demande: 17.08.1994
(73) Titulaire: THOMSON-CSF, 75008 Paris (FR)
(72) Inventeur: Robin, Philippe, F-92402 Courbevoie Cedex (FR); Bureau, Jean-Marc, F-92402 Courbevoie Cedex (FR); Bernard, François, F-92402 Courbevoie Cedex (FR); Facoetti, Hugues, F-92402 Courbevoie Cedex (FR)
(74) Mandataire: Guérin, Michel

(56) Documents cités:
- EP-A- 0 284 131
- EP-A- 0 413 461
- EP-A- 0 435 397
- EP-A- 0 491 596
- PATENT ABSTRACTS OF JAPAN vol. 7, no. 272 (E-214)13 Décembre 1983 & JP-A-58 154 151 (MATSUSHITA DENKI SANGYO KK)

## Description

La présente invention concerne le domaine général des détecteurs infrarouge fonctionnant à température ambiante et notamment des procédés de réalisation d'un détecteur comprenant un matériau pyroélectrique.

Actuellement, il existe des détecteurs thermiques permettant de réaliser en particulier des imageurs infrarouge, ces détecteurs fonctionnant à l'ambiante sans système de refroidissement. Pour fonctionner correctement, le matériau sensible compris dans le détecteur, est chauffé par le rayonnement infrarouge. Sous l'élévation de température, il peut apparaître des charges (détecteur pyroélectrique), des variations de constante diélectrique (bolomètre diélectrique), des variations de résistance (bolomètre résistif)... Le problème majeur de ces détecteurs est de confiner la chaleur au sein du matériau sensible, en évitant au maximum les pertes par diffusion au sein du substrat comprenant les circuits de lecture de la réponse du matériau sensible.

Différentes solutions d'isolation du matériau sensible ont déjà été envisagées. Il peut s'agir par exemple de rapporter l'élément sensible sur le circuit de lecture par l'intermédiaire de plots de résine epoxy conductrice.

Il peut également s'agir d'utiliser des plots de polyimide métallisés (Brevet Hughes US 4 740 700) comme l'illustre la figure 1. Dans ces deux cas, on utilise un procédé hybride difficile, voire impossible à mettre en oeuvre de manière collective c'est-à-dire que les matrices de détecteurs sont réalisées une par une.

Une autre solution propose d'utiliser comme couche sensible des polymères pyroélectriques de faible conductivité pouvant s'accommoder d'une isolation thermique moins sophistiquée (FR 89 08799). Il est notamment proposé d'utiliser par exemple une couche de diélectrique classique type polyimide, entre le circuit de lecture en silicium et le polymère pyroélectrique. D'autres documents EP-A-0 284 131 ; EP-A-0 435 397 ; Patents Abstracts of Japan, vol. 7, n° 272 (E-214) 13 Décembre 1983 & JP-A-58 154 151 enseignent également l'association de couche pyroélectrique et de couche thermiquement isolante. On parvient ainsi à réduire les pertes par diffusion au niveau de la couche sensible, avec un mode de fabrication collectif de type microélectronique mais les performances et les sensibilités de ces détecteurs nécessitent encore de se tourner vers d'autres solutions pour améliorer davantage l'isolation thermique.

L'invention a pour objet un procédé de réalisation de détecteur thermique comprenant un substrat et une couche de matériau sensible au rayonnement infrarouge caractérisé en ce qu'il comprend les étapes suivantes :
- la réalisation d'une couche C₁ de polymère dissous dans un solvant A, sur le substrat ;
- la démixtion de la couche C₁ provoquant l'apparition d'une couche hétérogène à deux phases ;
- l'élimination du solvant A permettant d'obtenir une couche C'₁ de polymère ayant une structure microporeuse de conductivité thermique réduite ;
- la réalisation de la couche C₂ de matériau sensible sur ladite couche C'₁.

L'étape de démixtion peut avantageusement être obtenue par immersion de la couche C₁ sur le substrat dans un produit B non solvant du polymère et miscible avec le solvant A. L'élimination du solvant peut alors être effectuée simultanément avec celle du produit B par traitement thermique.

Dans le procédé de réalisation de détecteur thermique, le polymère dissous dans le solvant A peut avantageusement être un précurseur du polyimide. L'étape d'élimination du solvant A est dans ce cas, suivie d'un traitement thermique à haute température de manière à transformer le précurseur en polyimide.

L'étape de démixtion peut également être obtenue par traitement thermique à une température T₁ telle qu'il y ait apparition de séparation de phase à cette température le solvant du polymère est ensuite évaporé sous vide à cette température.

Le matériau sensible de la couche C₂ peut être de type polymère pyroélectrique facilement déposable en couche mince. Il peut notamment s'agir de polymère de type polyfluorure de vinylidène ou de type polyfluorure de vinylidène-trifluoroéthylène.

Le matériau sensible de la couche C₂ peut également être une céramique ferroélectrique que l'on peut déposer en couche mince notamment par des techniques sol-gel. L'intérêt de ces procédés de réalisation est de ne faire appel qu'à des techniques couches minces permettant l'obtention de détecteurs infrarouge de faible dimension.

Enfin, on notera qu'un perfectionnement de l'invention consiste à faire en sorte que les micropores de la couche polymère soient remplis non pas d'air mais d'une substance ayant de meilleures propriétés d'isolation thermique que l'air, pour aboutir à une couche encore plus isolante thermiquement. Le xénon est particulièrement approprié : il peut facilement être incorporé à la couche et y rester piégé.

L'invention sera mieux comprise et d'autres avantages apparaîtront à la lecture de la description qui va suivre, donnée à titre non limitatif et grâce aux figures annexées parmi lesquelles :
- la figure 1 illustre un détecteur thermique selon l'art antérieur comprenant des plots conducteurs permettant de découpler thermiquement le matériau sensible du substrat de lecture;
- la figure 2 illustre une étape de procédé de réalisation de détecteur thermique selon l'invention conduisant à l'obtention d'une couche poreuse de polymère expansé déposée sur un substrat comprenant un circuit de lecture ;
- la figure 3 illustre une étape de réalisation de vias de connexion au travers de la couche poreuse, dans le procédé de réalisation de détecteur thermique selon l'invention;
- la figure 4 illustre un exemple de détecteur thermique obtenu par le procédé selon l'invention comprenant une couche de polymère ferroélectrique.

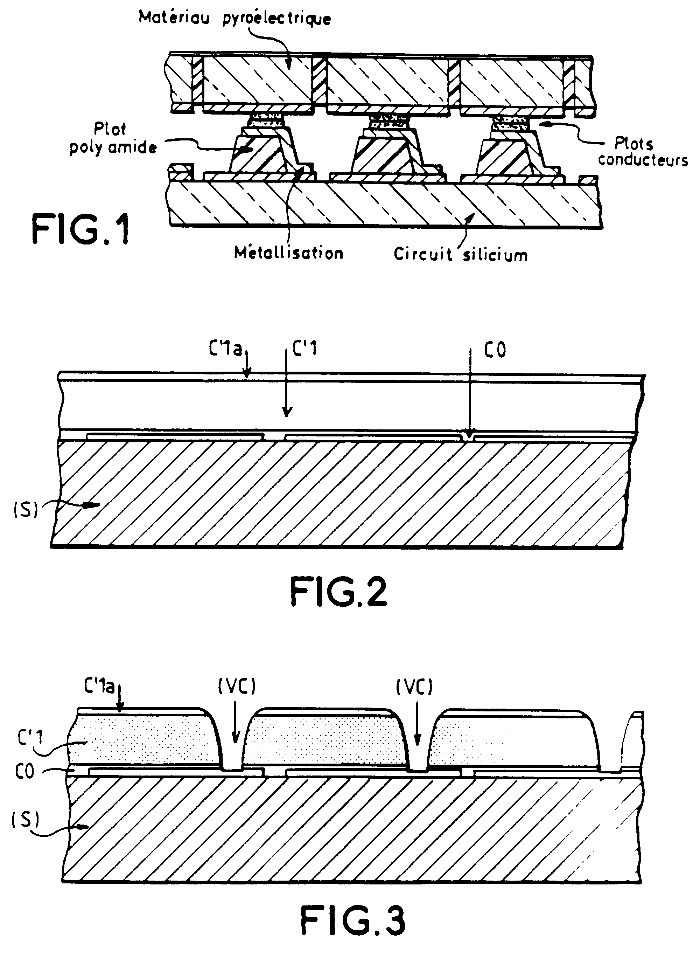

La figure 1 représente un détecteur infrarouge à base de matériau pyroélectrique selon la Demande de Brevet Hugues citée précédemment. Ce détecteur comprend des éléments en matériau pyroélectrique, à raison d'un par pixel, compris entre une électrode continue et des électrodes élémentaires. Des plots conducteurs relient électriquement les électrodes élémentaires aux entrées de circuits de traitement élaborés sur un substrat semiconducteur. Ce type de structure hybride reste beaucoup plus complexe que les structures réalisables uniquement par des techniques collectives en couches minces telles que celles utilisées en microélectronique. C'est pourquoi l'invention comme revendiquée propose un procédé de réalisation d'un détecteur thermique dans lequel l'emploi d'un matériau thermostable déposable en couche mince et de conductivité thermique notablement réduite permet d'élaborer une structure dans laquelle on réalise une couche mince de matériau sensible sur un substrat comprenant un circuit de lecture, ladite couche étant découplée thermiquement du substrat par une couche de matériau thermostable.

Le substrat employé peut avantageusement être un substrat semiconducteur de type silicium comportant des circuits de lecture. Dans le cas de détecteur matriciel intéressant en imagerie infrarouge, le substrat peut comporter des circuits de traitement et une matrice à 2 dimensions de commutateurs de lecture.

Le détecteur thermique obtenu selon l'invention comme revendiquée comprend une couche constituant la barrière thermique, cette couche étant munie de vias conducteurs, permettant d'assurer les contacts électriques entre les éléments du circuit de lecture et les électrodes inférieures dont est munie la couche de matériau sensible dont on veut enregistrer les variations physiques au cours d'une variation de température.

De préférence la couche constituant la barrière thermique est une couche de polymère thermostable de type polyimide. Cette couche peut être obtenue à partir d'une solution par un procédé classique d'enduction (spray, centrifugation, coulage...). On peut avantageusement utiliser une solution de précurseur de polymère de type polyimide (le polyimide étant difficilement soluble) classiquement utilisée pour la réalisation de couches isolantes en microélectronique.

Avant séchage de cette solution, on applique la technique dite de séparation de phase ou d'inversion de phase dont le but est de transformer dans cette couche, la solution, au départ homogène, en un système biphasique permettant d'obtenir une phase riche en polymère qui va constituer après séchage un réseau solide, et, une phase pauvre en polymère qui va constituer un réseau de pores. Cette structure complexe conduit ainsi à l'élaboration d'un polymère de structure microporeuse dont la conductivité thermique est notablement abaissée, après évaporation d'un solvant de la solution initiale renfermant le polymère thermostable.

Plusieurs procédés peuvent être mis en oeuvre pour réaliser cette technique d'inversion de phase. De façon préférentielle l'opération d'inversion de phase peut être obtenue par coagulation de la solution en l'immergeant dans un bain de non solvant du polymère, mais miscible avec le solvant de ladite solution.

Après élimination du solvant et du non-solvant par séchage et après traitement thermique pour stabiliser la structure notamment dans le cas d'un précurseur de polyimide que l'on veut imidiser on obtient un polymère "expansé" dont la structure microporeuse lui confère une faible densité et ainsi une conductivité thermique réduite. La couche ainsi obtenue peut typiquement avoir une épaisseur comprise entre 1 micron et quelques centaines de microns.

Afin d'assurer une bonne adhérence de la couche poreuse sur le substrat, en particulier, lors de la phase de coagulation, on peut utiliser une couche C₀ d'accrochage ou un promoteur d'adhérence. Il peut s'agir dans le cas particulier des polyimides, d'aminosilanes ou de chélate d'aluminium. Il est également possible de réaliser, préalablement au dépôt de la couche de polymère qui sera rendue poreuse, une fine couche de polymère (de préférence le même) séchée mais non totalement recuite afin de pouvoir s'allier à cette couche lors du traitement thermique final.

Afin d'assurer l'étanchéité et le bon état de surface de la couche poreuse, on peut également densifier une zone superficielle C'₁ₐ en soumettant la face supérieure du dépôt, à un séchage sommaire avant l'étape d'inversion de phase. Ce séchage sommaire est opéré en réalisant un gradient de température au sein de la couche. Pour cela on peut envoyer superficiellement un flux gazeux, ou déposer le substrat recouvert de la couche au coeur d'une étuve, l'ensemble substrat/couche reposant sur une plaque refroidie, pour assurer le gradient de température nécessaire au sein de la couche. La gravure des vias de connexion peut s'effectuer de manière analogue à celle des polymères classiques utilisés en microélectronique. Il peut s'agir de gravure plasma ou de photoablation par laser Excimère. Il suffit ensuite de déposer localement des métallisations pour assurer les contacts entre les circuits de lecture et les électrodes inférieures de la couche sensible. Notons que la structure cellulaire de la couche thermiquement isolante permet de graver celle-ci à une vitesse supérieure à celle du même polymère non expansé ce qui permet ainsi de réaliser des couches d'épaisseur plus importante tout en conservant le même procédé de gravure.

### Exemple d'un procédé de réalisation d'un détecteur thermique selon l'invention comme revendiquée, à base de matériau ferroélectrique.

Sur un substrat de silicium comportant des circuits de lecture, on applique une première couche mince de solution d'acide polyamique (par exemple le matériau référencé PIQ 13 HITACHI) précurseur de polyimide dissous dans le solvant A soit la N Methyl-Pyrrolidone, par centrifugation à la tournette. La dilution de la solution et la vitesse de centrifugation sont adjustées afin d'obtenir une épaisseur finale de l'ordre de 0,5 µm. Cette couche est alors séchée durant 10 minutes à 200°C et constitue une couche d'accrochage C₀ sur le substrat (S). Sur cette couche, on dépose la couche destinée à être expansée. La solution est alors plus concentrée et la vitesse de centrifugation est réduite pour obtenir une épaisseur plus importante (de l'ordre de 10 µm).

Afin de densifier la zone superficielle C'₁ₐ de cette couche, le solvant A est évaporé sommairement en surface du dépôt dans une étuve ventilée à 80°C, pendant 2 minutes.

L'inversion de phase est ensuite effectuée en plongeant le substrat recouvert de la couche d'accrochage et de la couche partiellement densifiée, dans une grande quantité de non solvant B sous agitation. Ce non solvant peut être du méthanol ou un solvant chloré, miscible avec la N-Methyl Pyrrolidone. Au bout de quelques minutes la couche à l'origine transparente devient totalement diffusante lors de la séparation du milieu en deux phases.

Pour éliminer le solvant A et le non solvant B, la couche est séchée sous vide puis traitée thermiquement à 300°C pour transformer l'acide polyamique en polyimide. On obtient alors la couche C'₁ et une structure illustrée à la figure 2.

Les vias de connexion (VC) sont ensuite gravés dans cette couche de polymère expansé pour accéder aux éléments de lecture comme l'illustre la figure 3, par gravure ionique réactive.

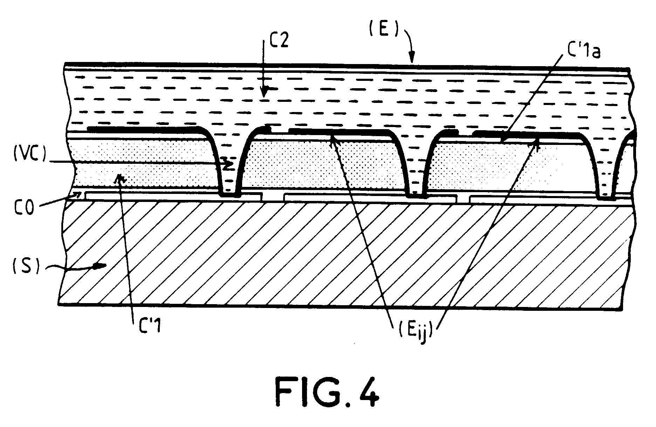

On réalise ensuite la métallisation des vias puis la gravure par photolithographie des zones dans lesquelles on veut supprimer les métallisations de manière à définir un arrangement matriciel des électrodes inférieures (Eij) du détecteur thermique, lesdites électrodes étant ainsi déconnectées entre elles et reliées au circuit de lecture du substrat (S) comme le montre la figure 4. Sur ces électrode (Eij) on dépose alors la couche de matériau sensible, par exemple une couche de polymère pyroélectrique de conductivité thermique réduite : par exemple, un copolymère PVDF - TrFE 75-25 (75 % en moles de PVDF pour 25 % en moles de TrFE) dans la dimethylformamide (DMF). Plusieurs couches de polymère pyroélectrique peuvent ainsi être déposées par centrifugation pour obtenir une épaisseur comprise entre 5 et plusieurs dizaines de microns.

Sur cette dernière couche, on dépose alors une électrode continue (E) pour constituer une contre-électrode, par exemple sous forme d'une couche d'aluminium de 1000 10⁻¹⁰ m (Angströms) d'épaisseur, par évaporation sous vide.

Une dernière couche d'absorbant infrarouge (A) peut être enfin déposée sur l'électrode continue (E) ; il peut s'agir notamment de noir d'aluminium obtenu par évaporation d'aluminium sous atmosphère d'azote selon une technique connue.

L'électrode continue (E) peut également assurer la fonction de la couche (A) en étant en métal de type titane ou chrome.

Après avoir polarisé le matériau polymère pyroélectrique, typiquement avec un champ électrique continu voisin de 100 V/µm, le détecteur thermique ainsi obtenu est en mesure de fonctionner.

Les performances d'un tel détecteur ont pu être comparées à celles d'un détecteur élaboré à partir d'un film de polymère pyroélectrique déposé sur une couche isolante de polyimide dense.

Avec un film autosupporté de polymère ferroélectrique de 10 µm d'épaisseur, on mesure un courant pyroélectrique normalisé à 1 sous l'influence d'un rayonnement laser CO₂ à 10,6 µm à une fréquence de 50 Hz.

Pour un film de 10 µm de polymère ferroélectrique déposé sur un film de 20 µm d'épaisseur de polyimide dense, le courant pyroélectrique mesuré et normalisé chute à 0,4.

Pour un film de 7 µm de polymère ferroélectrique (donc moins épais et générant par la même moins de charges pyroélectriques), déposé sur un film de 14 µm d'épaisseur de polyimide "expansé" de structure poreuse, le courant pyroélectrique mesuré et normalisé est voisin de 0,95. Ceci constitue un résultat très concluant quant à l'isolation thermique conférée par la couche de diélectrique de structure poreuse.

Pour améliorer encore les propriétés d'isolation thermique de la couche microporeuse réalisée selon l'invention comme revendiquée, on peut prévoir que les micropores de la couche sont remplis non pas d'air mais d'une substance qui a un coefficient d'isolation thermique meilleur que celui de l'air. La substance peut être liquide ou gazeuse. A titre d'exemple, les pores peuvent être remplis de xénon qui est meilleur isolant thermique que l'air. Le xénon se place dans les pores par exemple si on effectue les recuits d'élimination de solvants en atmosphère de xénon au lieu de les effectuer en atmosphère ambiante. Après formation de la couche microporeuse, le xénon reste piégé dans les pores.

## Revendications

1. Procédé de réalisation d'un détecteur thermique comprenant un substrat et une couche (C₂) de matériau sensible au rayonnement infrarouge caractérisé en ce qu'il comprend les étapes suivantes :
• la réalisation d'une première couche (C₁) de polymère dissous dans un solvant A, sur le substrat ;
• la démixtion de la première couche (C₁) provoquant l'apparition d'une couche hétérogène à deux phases ;
• l'élimination du solvant A permettant d'obtenir une couche obtenue (C'₁) de polymère ayant une structure microporeuse de conductivité thermique réduite ;
• la réalisation de la couche (C₂) de matériau sensible sur ladite couche obtenue (C'₁).

2. Procédé de réalisation d'un détecteur thermique selon la revendication 1 caractérisé en ce que l'étape de démixtion est effectuée par immersion de la première couche (C₁) sur le substrat, dans un produit B non solvant du polymère et miscible avec le solvant A.

3. Procédé de réalisation d'un détecteur thermique selon la revendication 2 caractérisé en ce que l'élimination du solvant A est effectuée simultanément avec celle du produit B, par traitement thermique.

4. Procédé selon la revendication 3, caractérisé en ce que le traitement thermique est réalisé en atmosphère d'un gaz ayant des propriétés d'isolation thermique meilleures que celles de l'air, de manière à remplir de ce gaz les micropores se formant dans la couche de polymère.

5. Procédé selon la revendication 4, caractérisé en ce que le gaz est du xénon.

6. Procédé de réalisation d'un détecteur thermique selon l'une des revendications 1 à 5, caractérisé en ce que le polymère dissous dans le solvant A, est un précurseur de polyimide.

7. Procédé de réalisation d'un détecteur thermique selon la revendication 5, caractérisé en ce que l'étape d'élimination du solvant A est suivi d'un traitement thermique à haute température de manière à transformer le précurseur en polyimide.

8. Procédé de réalisation d'un détecteur thermique selon l'une des revendications 6 ou 7, caractérisé en ce que le polymère est de l'acide polyamique dissous dans de la N-MethylPyrrolidone.

9. Procédé de réalisation d'un détecteur thermique selon l'une des revendications 7 ou 8, caractérisé en ce que le produit B est du méthanol.

10. Procédé de réalisation d'un détecteur thermique selon l'une des revendications 1 à 9, caractérisé en ce que le matériau sensible de la couche (C₂) de matériau sensible est un polymère de type polyfluorure de vinylidène, ou de type polyfluorure de vinylidène-trifluoroéthylène.

11. Procédé de réalisation d'un détecteur thermique selon l'une des revendications 1 à 10, caractérisé en ce que l'obtention de la couche (C₂) de matériau sensible est suivie d'une étape de réalisation de vias de connexion, par gravure.

12. Procédé de réalisation d'un détecteur thermique selon la revendication 11, caractérisé en ce que la réalisation des vias de connexion est suivie d'une étape de métallisation, puis d'une étape de photolithographie pour définir des électrodes discrètes (Eij) au-dessus de la couche (C₂) de matériau sensible.

13. Procédé de réalisation d'un détecteur thermique selon l'une des revendications 1 à 12, caractérisé en ce qu'une électrode continue (E) est déposée sur la couche de matériau sensible.

14. Procédé de réalisation d'un détecteur thermique selon l'une des revendications 1 et 2, caractérisé en ce qu'on remplit les micropores qui se forment dans la couche obtenue de polymère, avec une substance ayant un coefficient d'isolation thermique meilleur que celui de l'air.

## Patentansprüche

1. Verfahren zur Herstellung eines Thermodetektors mit einem Substrat und einem Überzug (C₂) aus einem gegenüber Infrarotstrahlung empfindlichen Material, dadurch gekennzeichnet, daß das Verfahren die folgenden Schritte umfaßt:
- Herstellen eines ersten Überzugs (C₁) aus einem in einem Lösungsmittel A gelösten Polymer auf dem Substrat;
- Entmischen des ersten Überzugs (C₁), wobei das Auftreten eines heterogenen Zweiphasenüberzugs eingeleitet wird;
- Entfernen des Lösungsmittels A unter Erhalt eines so erhaltenen Überzugs (C'₁) aus einem eine mikroporöse Struktur mit verminderter Wärmeleitfähigkeit aufweisenden Polymer;
- Herstellen des Überzugs (C₂) aus dem empfindlichen Material auf dem so erhaltenen Überzug (C'₁).

2. Verfahren zur Herstellung eines Thermodetektors nach Anspruch 1, dadurch gekennzeichnet, daß der Schritt des Entmischens durch Eintauchen des ersten Überzugs (C₁) auf dem Substrat in ein das Polymer nicht lösendes und mit dem Lösungsmittel A mischbares Produkt B bewirkt wird.

3. Verfahren zur Herstellung eines Thermodetektors nach Anspruch 2, dadurch gekennzeichnet, daß die Entfernung des Lösungsmittels A gleichzeitig mit der Entfernung des Produkts B mittels einer Wärmebehandlung bewirkt wird.

4. Verfahren nach Anspruch 3, dadurch gekennzeichnet, daß die Wärmebehandlung in einer Gasatmosphäre durchgeführt wird, wobei die Gasatmosphäre bessere Wärmedämmeigenschaften als Luft aufweist, und wobei die Wärmebehandlung so durchgeführt wird, daß sich die in dem Polymerüberzug bildenden Mikroporen mit dem Gas füllen.

5. Verfahren nach Anspruch 4, dadurch gekennzeichnet, daß das Gas Xenon ist.

6. Verfahren zur Herstellung eines Thermodetektors nach einem der Ansprüche 1 bis 5, dadurch gekennzeichnet, daß das in dem Lösungsmittel A gelöste Polymer ein Polyimidvorläufer ist.

7. Verfahren zur Herstellung eines Thermodetektors nach Anspruch 5, dadurch gekennzeichnet, daß auf den Schritt der Entfernung des Lösungsmittels A eine Wärmebehandlung bei hoher Temperatur zur Umwandlung des Vorläufers in Polyimid folgt.

8. Verfahren zur Herstellung eines Thermodetektors nach einem der Ansprüche 6 oder 7, dadurch gekennzeichnet, daß das Polymer ein in N-Methylpyrrolidon gelöstes polymeres Säureamid ist.

9. Verfahren zur Herstellung eines Thermodetektors nach einem der Ansprüche 7 oder 8, dadurch gekennzeichnet, daß das Produkt B Methanol ist.

10. Verfahren zur Herstellung eines Thermodetektors nach einem der Ansprüche 1 bis 9, dadurch gekennzeichnet, daß das empfindliche Material des Überzugs (C₂) aus dem empfindlichen Material ein Polymer des Typs Polyvinylidenfluorid oder des Typs Polyvinylidenfluorid-Trifluorethylen ist.

11. Verfahren zur Herstellung eines Thermodetektors nach einem der Ansprüche 1 bis 10, dadurch gekennzeichnet, daß auf den Erhalt des Überzugs (C₂) aus dem empfindlichen Material ein Schritt der Herstellung von Kontaktlochverbindungen durch Ätzen folgt.

12. Verfahren zur Herstellung eines Thermodetektors nach Anspruch 11, dadurch gekennzeichnet, daß auf die Herstellung der Kontaktlochverbindungen ein Schritt der Metallisierung folgt, gefolgt von einem Photolithographieschritt zur Ausbildung von diskreten Elektroden (Eij) auf dem Überzug (C₂) aus dem empfindlichen Material.

13. Verfahren zur Herstellung eines Thermodetektors nach einem der Ansprüche 1 bis 12, dadurch gekennzeichnet, daß auf dem Überzug aus dem empfindlichen Material eine kontinuierliche Elektrode (E) abgeschieden wird.

14. Verfahren zur Herstellung eines Thermodetektors nach einem der Ansprüche 1 oder 2, dadurch gekennzeichnet, daß die sich in dem erhaltenen Polymerüberzug bildenden Mikroporen mit einer Substanz gefüllt werden, die einen besseren Wärmeisolationskoeffizienten aufweist als Luft.

## Claims

1. Process for producing a thermal detector which includes a substrate and a layer (C₂) of material sensitive to infrared radiation, characterized in that it includes the following steps:
· production, on the substrate, of a first layer (C₁) of polymer dissolved in a solvent A;
· segregation of the first layer (C₁), causing the appearance of a heterogeneous two-phase layer;
· removal of the solvent A, making it possible to form an obtained layer (C'₁) of polymer having a microporous structure of reduced thermal conductivity;
· production of the layer (C₂) of sensitive material on the said obtained layer (C'₁).

2. Process for producing a thermal detector according to Claim 1, characterized in that the segregation step is carried out by immersing the first layer (C₁) on the substrate in a substance B which is not a solvent for the polymer and is miscible with the solvent A.

3. Process for producing a thermal detector according to Claim 2, characterized in that the removal of the solvent A is carried out, simultaneously with that of the substance B, by heat treatment.

4. Process according to Claim 3, characterized in that the heat treatment is carried out in an atmosphere of a gas having thermal insulation properties that are superior to those of air, so as to fill the micropores being formed in the polymer layer with this gas.

5. Process according to Claim 4, characterized in that the gas is xenon.

6. Process for producing a thermal detector according to one of Claims 1 to 5, characterized in that the polymer dissolved in the solvent A is a polyimide precursor.

7. Process for producing a thermal detector according to Claim 5, characterized in that the step of removing the solvent A is followed by a high-temperature heat treatment so as to convert the precursor into a polyimide.

8. Process for producing a thermal detector according to either of Claims 6 and 7, characterized in that the polymer is polyamic acid dissolved in N-methyl-pyrrolidone.

9. Process for producing a thermal detector according to either of Claims 7 and 8, characterized in that the substance B is methanol.

10. Process for producing a thermal detector according to one of Claims 1 to 9, characterized in that the sensitive material of the layer (C₂) of sensitive material is a polymer of the poly(vinylidene fluoride) type or of the poly(vinylidene fluoride-trifluoroethylene) type.

11. Process for producing a thermal detector according to one of Claims 1 to 10, characterized in that the formation of the layer (C₂) of sensitive material is followed by a step in which connection vias are produced by etching.

12. Process for producing a thermal detector according to Claim 11, characterized in that the production of the connection vias is followed by a metallization step and then a photolithography step in order to define discrete electrodes (Eᵢⱼ) on top of the layer (C₂) of sensitive material.

13. Process for producing a thermal detector according to one of Claims 1 to 12, characterized in that a continuous electrode (E) is deposited on the layer of sensitive material.

14. Process for producing a thermal detector according to either of Claims 1 and 2, characterized in that the micropores which are formed in the obtained layer of polymer are filled with a substance having a thermal insulation coefficient superior to that of air.
